Europäisches Patentamt

European Patent Office

Office européen des brevets

(11) Veröffentlichungsnummer: **0 477 428 A1**

## (12) EUROPÄISCHE PATENTANMELDUNG

(21) Anmeldenummer: **90118727.8**

(22) Anmeldetag: **28.09.90**

(51) Int. Cl.⁵: **H01L 29/73**

(43) Veröffentlichungstag der Anmeldung:
**01.04.92 Patentblatt 92/14**

(84) Benannte Vertragsstaaten:
**AT BE CH DE DK ES FR GB GR IT LI LU NL SE**

(71) Anmelder: **SIEMENS AKTIENGESELLSCHAFT**

Wittelsbacherplatz 2
W-8000 München 2(DE)

(72) Erfinder: **Dathe, Joachim, Dipl.-Phys.**
**Schleissheimer Strasse 276**
**W-8000 München 40(DE)**

(54) **Halbleiterchip mit mindestens einer elektrischen Widerstandseinrichtung.**

(57) Ein Halbleiterchip mit mindestens einer elektrischen Widerstandseinrichtung (2, 3), mindestens einem im Halbleiterchip integrierten Halbleiterbauelement (1) und mindestens einer Metallisierung (12) für das Halbleiterbauelement (1) auf dem Halbleiterchip, soll eine Verminderung des Platzbedarfs auf dem Halbleiterchip für Widerstandseinrichtungen ermöglichen. Mindestens eine Widerstandseinrichtung (2, 3) ist wenigstens teilweise unter der Metallisierung (12) angeordnet.

FIG 2

EP 0 477 428 A1

Die Erfindung betrifft einen Halbleiterchip mit mindestens einer elektrischen Widerstandseinrichtung nach dem Oberbegriff des Patentanspruchs 1.

Die Erfindung bezweckt eine platzsparende Konstruktion von elektrischen Widerständen für Halbleiterbauelemente.

Die Erfindung ist anwendbar für Halbleiterbauelemente mit Widerstandsnetzwerken. Die Erfindung eignet sich insbesondere für Silizium-Planarbauelemente.

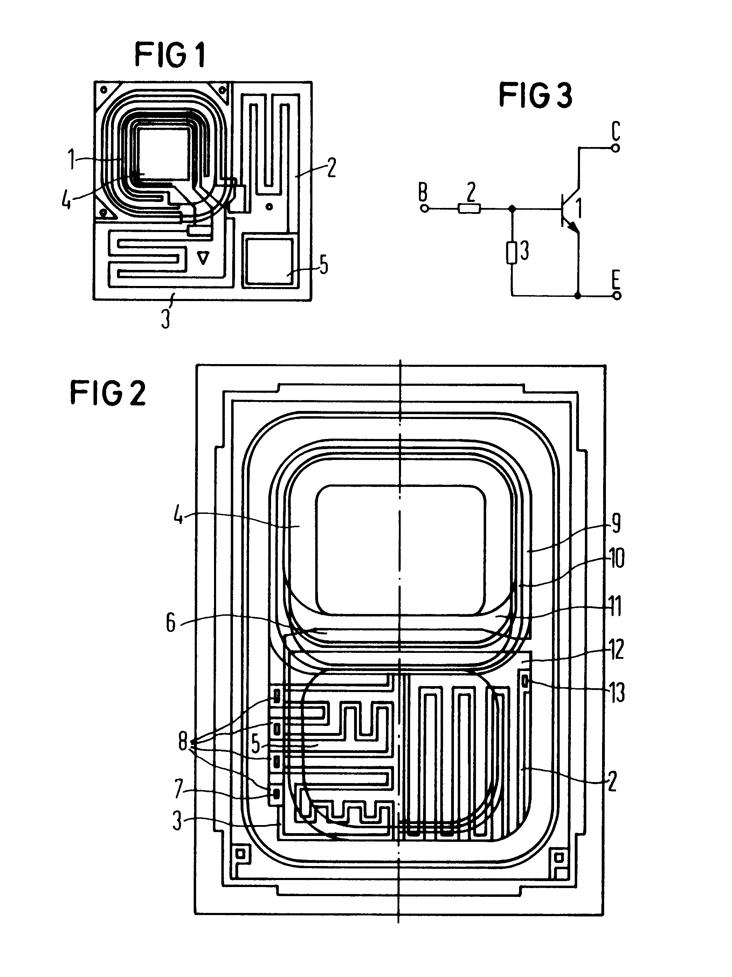

FIG 1 zeigt eine Draufsicht auf einen Bipolartransistor 1 nach dem Stand der Technik mit Zwei Widerständen 2 und 3. Die an das aktive Halbleiterbauelement 1, z. B. an einen Bipolartransistor, geschalteten Widerstände 2, 3 sind dabei neben diesem Halbleiterbauelement 1 angeordnet, wie das Beispiel eines Bipolartransistors nach FIG 1 mit den beiden elektrischen Widerständen 2, 3 zeigt. Der Widerstand 2 ist dabei ein Basisvorwiderstand und hat einen Widerstandswert von 50 kOhm oder weniger. Der Widerstand 3 ist ein Emitter-Basis-Parallelwiderstand und hat ebenfalls einen Widerstandswert von 50 kOhm oder weniger. Das Halbleiterbauelement 1 besitzt eine Emitter-Anschlußmetallisierung (Emitter-Pad) 4 und eine Basis-Anschlußmetallisierung (Basis-Pad) 5. Der erhebliche Platzbedarf für die beiden Widerstandsmeander 2, 3 in FIG 1 ist offensichtlich. Für den Halbleiterchip, der das Halbleiterbauelement 1 und die Widerstände 2, 3 umfaßt, wird mehr als die doppelte Chipfläche eines Halbleiterchips benötigt, der nur den Einzeltransistor 1 umfassen würde.

Der vorliegenden Erfindung liegt die Aufgabe Zugrunde, einen Halbleiterchip der eingangs genannten Art anzugeben, der eine Verminderung des Platzbedarfs auf dem Halbleiterchip für Widerstandseinrichtungen, insbesondere für Widerstandseinrichtungen mit hohen Ohmwerten, ermöglicht.

Diese Aufgabe wird erfindungsgemäß durch einen Halbleiterchip nach Patentanspruch 1 gelöst.

Ausgestaltungen und Vorteile der Erfindung sind in den Unteransprüchen, der Beschreibung und der Zeichnung angegeben.

Um den erheblichen Flächenbedarf für einen Halbleiterchip, der neben mindestens einem Halbleiterbauelement auch noch mindestens eine Widerstandseinrichtung aufweist, zu reduzieren, wird mindestens eine Widerstandseinrichtung zumindest teilweise unter einem Anschlußflecken (Anschlußmetallisierung, Anschluß-Pad) angeordnet. Eine Widerstandseinrichtung kann im Halbleiterchip integriert sein. Eine Widerstandseinrichtung kann jedoch auch auf die Oberfläche des Halbleiterchips aufgebracht sein, beispielsweise durch Aufdampfen oder durch eine sonstige dem Fachmann bekannte Maßnahme.

Die Chipfläche eines Halbleiterchips nach der Erfindung kann bei gleicher elektrisch aktiver Fläche beispielsweise 40 % der beim Stand der Technik benötigten Chipfläche betragen.

Die Erfindung wird im folgenden anhand der Zeichnung näher erläutert.

FIG 1 zeigt eine Draufsicht auf einen Halbleiterchip nach dem Stand der Technik.

FIG 2 zeigt eine Draufsicht auf einen Halbleiterchip nach der Erfindung.

FIG 3 zeigt ein Ersatzschaltbild für eine Anordnung nach FIG 2.

FIG 2 zeigt ein Ausführungsbeispiel anhand eines Silizium-Planartransistors mit Widerstandsnetzwerk entsprechend einem Ersatzschaltbild gemäß FIG 3.

Um den erheblichen Flächenbedarf für die im Ausführungsbeispiel nach FIG 2 und für die nach dem bekannten Beispiel gemäß FIG 1 vorgesehenen elektrischen Widerstände 2, 3 zu reduzieren, werden diese Widerstandseinrichtungen 2, 3 im Ausführungsbeispiel nach FIG 2 zumindest teilweise unter der Basismetallisierung 12 angeordnet.

Die Chipfläche des Halbleiterchips nach FIG 3 beträgt bei gleicher elektrisch aktiver Fläche wie bei einem Beispiel nach FIG 1 nur 40 % der beim Halbleiterchip nach FIG 1 benötigten Chipfläche (FIG 1 und 2 sind in unterschiedlichen Maßstäben gezeichnet.)

Der im Halbleiterchip nach FIG 2 integrierte Silizium-Planartransistor besitzt einen annähernd quadratischen Emitterdiffusionsbereich 6 in einer in der FIG 2 dunkel dargestellten, in der FIG 2 unten verkürzten Basisdiffusionswanne 9.

Die Emittermetallisierung 11 befindet sich im Emitterdiffusionsbereich 6, während die Basismetallisierung 12 über die Basiswanne 9 hinaus auf die auf dem Halbleiterchip vorhandene Isolationsschicht herausgezogen ist. Die Isolationsschicht kann aus einem Schichtaufbau aus Siliziumdioxid und Siliziumnitrid bestehen. Unter der Basismetallisierung 12 sind zumindest teilweise die Widerstände 2, 3 angeordnet. Die Widerstände 2, 3 können gemeinsam mit der Basiswanne 9 hergestellt werden. Die Widerstände 2, 3 können durch Implantation, daran anschließende mögliche Nachdiffusion hergestellt werden. Daran anschließend kann zur Erzeugung einer Isolationsschicht eine Oxidation erfolgen.

Zur Herstellung eines 50 kOhm-Widerstands werden bei einem Basisschichtwiderstand von 200 ohm/square 250 squares aneinander gereiht. Das ergibt bei 4 $\mu$m Kantenlänge und 8 $\mu$m Streifenabstand bei den Widerstandsmäandern 2, 3 einen Platzbedarf für die beiden Widerstände 2, 3 mit je 50 kOhm, für insgesamt also 100 kOhm, von 120 x 190 $\mu$m$^2$. Dies entspricht der Fläche für moderne Bondflecken (Bondpads) einschließlich Überkontaktierbereich (Off-Pad-Bonding).

2

FIG 2 zeigt rechts eine einfache Mäanderkonstruktion für einen Basisvorwiderstand 2 von 47 kOhm, während links eine Mäanderkonstruktion für den Emitter-Basis-Parallelwiderstand 3 so ausgelegt ist, daß bei gleichem Widerstandsmäander für den Widerstand 3 vier Anzapfungen 8 für Widerstandswerte bei 4, 7 kOhm, bei 10 kOhm, bei 22 kOhm und bei 47 kOhm möglich sind. Durch Öffnen des entsprechenden Kontaktfensters bei dem Fotolithographie-Schritt, der zur Öffnung von Kontaktfenstern durchgeführt wird, kann für den jeweiligen speziellen Halbleiterchip der gewünschte Widerstandswert unter diesen vier Anzapfungen 8 ausgewählt und damit eingestellt werden. Der nicht benötigte Restteil des Widerstands 3 kann kurzgeschlossen werden.

Die gleiche Konstruktion mit verschiedenen Anzapfungen 8 kann auch für den Basisvorwiderstand 2 verwendet werden. Auf diese Weise können im Ausführungsbeispiel durch Änderungen der Maske für nur eine Ebene insgesamt 2 x 4 unterschiedliche Widerstandswerte für die Widerstände 2, 3 in unterschiedlicher Kombination erzeugt werden. Die Masken für die anderen Ebenen können dabei unverändert bleiben.

Durch Änderung des Basisschichtwiderstands, durch Zusatzimplantation im Widerstandsbereich oder durch andere geometrische Auslegung der Mäanderstreifen bzw. der Widerstandsstreifen (unterschiedliche Kantenlänge, unterschiedliche Abstände) der Widerstandseinrichtungen lassen sich weitere Variationen erzeugen.

In der Basiszone um die Emitterzone herum kann z. B. bei einer PNP-Version des Halbleiterbauelements eine $N^+$-Kontaktdiffusion eingebracht werden. Entsprechend kann bei einer NPN-Version des Halbleiterbauelements eine $P^+$-Diffusion in die Basiszone um die Emitterzone herum eingebracht werden.

Ein Halbleiterchip nach FIG 2 besitzt eine Basisanschlußdiffusion 10, einen Anschluß 13 an die Basismetallisierung 12 vom Basisvorwiderstand 2, einen Emitter-Bondflecken (Bondpad) 4, einen Basis-Bondflecken (Bondpad) 5 und eine Anschluß-Emittermetallisierung 7.

Als Halbleiterbauelemente können auch andere bekannte Halbleiterbauelemente als Bipolartransistoren, beispielsweise Dioden, sonstige Transistoren, Tetroden usw., verwendet werden.

Widerstandseinrichtungen können auch unter mehr als einer Anschlußmetallisierung angeordnet sein. Widerstandseinrichtungen können auch unter anderen Metallisierungen für den elektrischen Anschluß an ein Halbleiterbauelement, beispielsweise unter der Emitter-Metallisierung oder unter Metallisierungen, die für andere Halbleiterbauelemente benötigt werden beispielsweise unter einer Gate-Metallisierung, angeordnet sein.

**Patentansprüche**

1. Halbleiterchip mit mindestens einer elektrischen Widerstandseinrichtung (2, 3), mindestens einem im Halbleiterchip integrierten Halbleiterbauelement (1) und mindestens einer Metallisierung (12) für das Halbleiterbauelement (1) auf dem Halbleiterchip,
   **dadurch gekennzeichnet,** daß mindestens eine Widerstandseinrichtung (2, 3) wenigstens teilweise unter der Metallisierung (12) angeordnet ist.

2. Halbleiterchip nach Anspruch 1,
   **gekennzeichnet durch** eine Integration der elektrischen Widerstandseinrichtung (2, 3) im Halbleiterchip.

3. Halbleiterchip nach Anspruch 1 oder 2,
   **gekennzeichnet durch** einen Bipolartransistor als Halbleiterbauelement.

4. Halbleiterchip nach Anspruch 3,
   **gekennzeichnet durch** einen Basis-Anschluß als Metallisierung (12).

# FIG 1

# FIG 3

# FIG 2

**Europäisches Patentamt**

**EUROPÄISCHER RECHERCHENBERICHT**

Nummer der Anmeldung

**EP 90 11 8727**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X,Y | US-A-4 312 011   (HITACHI)<br>* Spalte 2, Zeile 60 - Spalte 3, Zeile 1; Figuren 1, 3c *<br>– – – | 1-3,4 | H 01 L 29/73 |
| X | FR-A-2 258 058   (BOSCH G.M.B.H.)<br>* Figur 5 *<br>– – – | 1-3 | |
| Y | PATENT ABSTRACTS OF JAPAN vol. 9, no. 19 (E-292) 25 Januar 1985,<br>& JP-A-59 167046 (NIPPON DENKI) 20 September 1984,<br>* das ganze Dokument *<br>– – – – – | 4 | |
| | | | **RECHERCHIERTE SACHGEBIETE (Int. Cl.5)**<br><br>H 01 L |

Der vorliegende Recherchenbericht wurde für alle Patentansprüche erstellt

| Recherchenort | Abschlußdatum der Recherche | Prüfer |
|---|---|---|
| Den Haag | 18 April 91 | NILES N.P.E. |